(19)

Europäisches
Patentamt
European
Patent Office
Office européen
des brevets

(11) **EP 1 709 732 B1**

(12) **EUROPEAN PATENT SPECIFICATION**

(45) Date of publication and mention
of the grant of the patent:
**01.09.2010 Bulletin 2010/35**

(51) Int Cl.:
*H03F 1/32* (2006.01)     *H03H 7/38* (2006.01)
*H03C 1/08* (2006.01)

(21) Application number: **05708140.8**

(22) Date of filing: **28.01.2005**

(86) International application number:
**PCT/FI2005/000059**

(87) International publication number:
**WO 2005/074124 (11.08.2005 Gazette 2005/32)**

(54) **ADJUSTING CIRCUIT**

EINSTELLSCHALTUNG

CIRCUIT D'AJUSTEMENT

(84) Designated Contracting States:
**AT BE BG CH CY CZ DE DK EE ES FI FR GB GR
HU IE IS IT LI LT LU MC NL PL PT RO SE SI SK TR**

(30) Priority: **30.01.2004 FI 20040140**

(43) Date of publication of application:
**11.10.2006 Bulletin 2006/41**

(73) Proprietor: **Nokia Corporation
02150 Espoo (FI)**

(72) Inventors:
• **KOUKKARI, Eero
FI-90530 Oulu (FI)**

• **OILINKI, Tero
FI-91600 Utajärvi (FI)**
• **KURTTIO, Pasi
FI-90100 Oulu (FI)**

(74) Representative: **Karppinen, Olavi Arto
Kolster Oy Ab
P.O. Box 148
Iso Roobertinkatu 23
00121 Helsinki (FI)**

(56) References cited:
**WO-A2-2004/038910     US-A- 4 538 122
US-A- 4 545 258**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Field**

The invention relates to an adjusting circuit for adjusting an amplitude of a signal.

**Background**

A non-linear element, for example a power amplifier, causes distortion to a signal. Reduction of distortion caused by amplifiers has been attempted by various means. Because the distortion of amplitude or phase of the amplified signal as a function of amplitude of an input signal often resembles a known function, distortion has been compensated with a component having a similar characteristic behaviour. Typical components for predistortion include a diode, a field effect transistor or a bipolar junction transistor. Although this solution is simple, it is also inaccurate. A characteristic curve of one component cannot cancel well enough the distortion of a non-linear element, such as a power amplifier. Although the components are used for linearizing the behaviour of a non-linear element, the components themselves also cause non-linearity in both phase and amplitude.

Patent document WO 97/28598 presents a linearity enhancing circuit for power amplifier. The circuit comprises a phase-amplitude controller which responds to changes in gain and phase through the RF/microwave power amplifier signal path caused by changes in RF input power, DC power supply voltages, time, temperature and other variables, and controls the operation of a gain and phase adjustment circuit, so as to maintain constant gain and transmission phase through the RF/microwave power amplifier.

Predistortion of amplitude can be performed by using look-up tables, which can be updated in order to achieve adaptability since amplifier distortion is affected by temperature, age of the amplifier and changes of the signal fed to the amplifier, for example.

Instead of look-up tables, a polynomial higher than the first order can be used to estimate distortion. Typically, the order has to be at least five or even seven for cancelling the distortion well enough. This, however, increases the number of multiplication operations drastically.

Look-up tables and polynomials result in complicated, slow and non-ideal compensation circuits which cause problematic delays in signal processing. Furthermore, multiplication operators used in a polynomial solution are difficult to implement and cause unnecessary delay. Irrespective of whether or not a linearization is used, power amplifiers cannot, thus, linearly amplify a signal if the power level of the incoming signal varies, which is the case e.g. in UMTS (Universal Mobile Telephone System), CDMA (Code Division Multiple Access), and WCDMA (Wide-band CDMA) radio systems.

**Brief description of the invention**

An object of the invention is to provide an improved adjusting circuit and an improved adjusting method.

According to an aspect of the invention, there is provided an adjusting circuit for adjusting an amplitude of a signal, the adjusting circuit comprising a plurality of terminals for input and output; and at least one pair of adjustable impedance means, wherein each pair of the adjustable impedance means is placed in between a pair of input and output terminals, in which the each pair of the adjustable impedance means is coupled in parallel between a signal line and ground, and the impedance means of the each pair of the adjustable impedance means having complementary reactances with respect to each other such that the impedances are complex conjugates.

According to another aspect of the invention, there is provided a method of adjusting an amplitude of a signal in an adjusting circuit, the adjusting circuit comprising a plurality of terminals for input and output; and at least one pair of adjustable impedance means, wherein each pair of the adjustable impedance means is placed between a pair of input and output terminals, each of the at least one pair of adjustable impedance means being coupled in parallel between a signal line and ground, the method comprising adjusting impedance of the adjusting circuit and keeping reactances of the adjustable impedance means of each pair complementary with respect to each other during the adjusting such that the impedances are complex conjugates.

Preferred embodiments of the invention are described in the dependent claims.

The adjusting circuit and method of the invention provide several advantages. The adjusting circuit is simple and provides a linear attenuation/control response of amplitude and phase in a wide frequency band.

**List of drawings**

In the following, the invention will be described in greater detail with reference to the preferred embodiments and the accompanying drawings, in which

Figure 1 shows a radio system;
Figure 2A illustrates an adjusting circuit with a transmission line;
Figure 2B illustrates an adjusting circuit with a directional coupler;
Figure 2C illustrates an adjusting circuit with a circulator;
Figure 3 illustrates an adjusting circuit between a signal generator and a load;
Figure 4 shows a Smith chart with a curve of an inductive adjusting impedance;
Figure 5 shows a Smith chart with a curve of a capacitive adjusting impedance;
Figure 6 shows a Smith chart with a curve of adjusting impedances in parallel coupling;
Figure 7 shows an inductive adjusting impedance implemented with capacitive diodes;
Figure 8 shows a capacitive adjusting impedance implemented with capacitive diodes;
Figure 9 shows a flow chart of the method; and
Figure 10 shows a flow chart of the method.

**Description of embodiments**

The present solution is particularly suitable for a transmitter in a radio system such as UMTS or WCDMA without, however, being limited thereto.

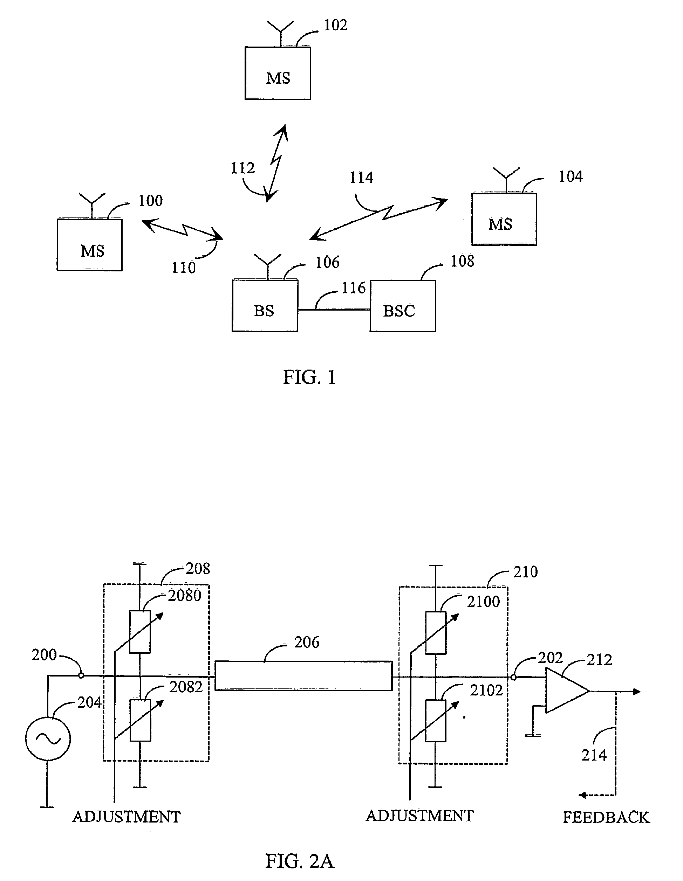

First the radio system is described by means of Figure 1. A typical digital radio system comprises subscriber equipment 100 to 104, at least one base station 106, and a base station controller 108. The base station 106 can also be called node B and the base station controller 108 can be called a radio network controller. The subscriber equipment 100 to 104 communicates with the base station 106 using signals 110 to 114. The base station 106 can be connected to the base station controller 108 by a digital transmission link 116. The subscriber equipment 100 to 104 may be fixedly installed terminals, user equipment installed in a vehicle or portable mobile terminals. The signals 110 to 114 between the subscriber equipment 100 to 104 and the base station 106 carry digitized information, e.g. speech or data information or control information produced by subscribers or by the radio system.

Figure 2A shows an adjusting circuit for adjusting the amplitude of a signal. The adjusting circuit in Figure 2A comprises an input terminal 200 and an output terminal 202. In general, the circuit may have a plurality of terminals for input and output. A signal generator 204, which may be a part of a transmitter in a base station or user equipment, supplies a signal to the input terminal 200. The circuit also includes a matching component 206 which has an effect on matching a signal input and a signal output to and from the terminals 200, 202. The matching component has an effect on the impedance of the circuit, and a matching component with different properties can change the impedance of the circuit. The matching component 206 may be, for instance, a transmission line, the length l of which can be one fourth of a wavelength $\lambda$ of the signal, i.e. $l = \lambda/4 + n\lambda/2$, where $n = 0, 1, 2, ..., \infty$. Correspondingly, the phase shift $\Delta\varphi$ (in radians) in the matching component can also be expressed as $\Delta\varphi = \pi/2 + n\pi$, where $\pi \approx 3.1415926$. The impedance of the transmission line can be 50$\Omega$, 75$\Omega$, 100$\Omega$, 600$\Omega$ or any other desired value. The adjusting circuit in Figure 2A comprises two adjustable resistance units 208, 210 between the matching component 206 and ground for changing resistance at the input and the output terminals 200, 202 of the amplitude adjusting circuit. A load 212, which may be a non-linear element such as an amplifier, can be coupled to the output terminal 202. The non-linearity in the amplitude caused by the load 212 may be cancelled with the adjusting circuit.

Instead of the transmission line 206 a ladder structure of coils and capacitances can be used. In this realization coils are coupled in series, and each coil has a both-sided coupling to ground by a capacitor. By selecting suitable values for coils and capacitances the required phase shift $\Delta\varphi = \pi/12 + n\pi$ can be achieved.

Each of the adjustable resistance units 208, 210 may include many components coupled in parallel and/or in series, at least some of the components being adjustable. The components in the resistance units 208, 210 also have complementary reactances with respect to each other. For example, the resistance unit 208 may include adjustable impedance units 2080, 2082, and the resistance unit 210 may include adjustable impedance units 2100, 2102. The impedance unit 2080 may be inductive and the impedance unit 2082 may be capacitive, or vice versa. During the adjustment of the impedance units 2080, 2082 in the resistance unit 208, their reactances may remain opposite to each other and the adjustment may only change the resistance value of the resistance unit 208. In a similar manner, the adjustment of the impedance units 2100, 2102 having complementary reactances may change the resistance of the resistance unit 210.

An embodiment of the present solution may include feedback 214 (shown with a dashed line) from the output of the non-linear element 212 to the adjustable resistance units 208, 210 for adjusting the impedance units 2080, 2082 and 2100, 2102, but this feature is not necessary. The feedback may comprise a feedback converter (not shown), which converts the output signal of the non-linear element 212 into a suitable form for the impedance units 2080, 2082 and 2100, 2102.

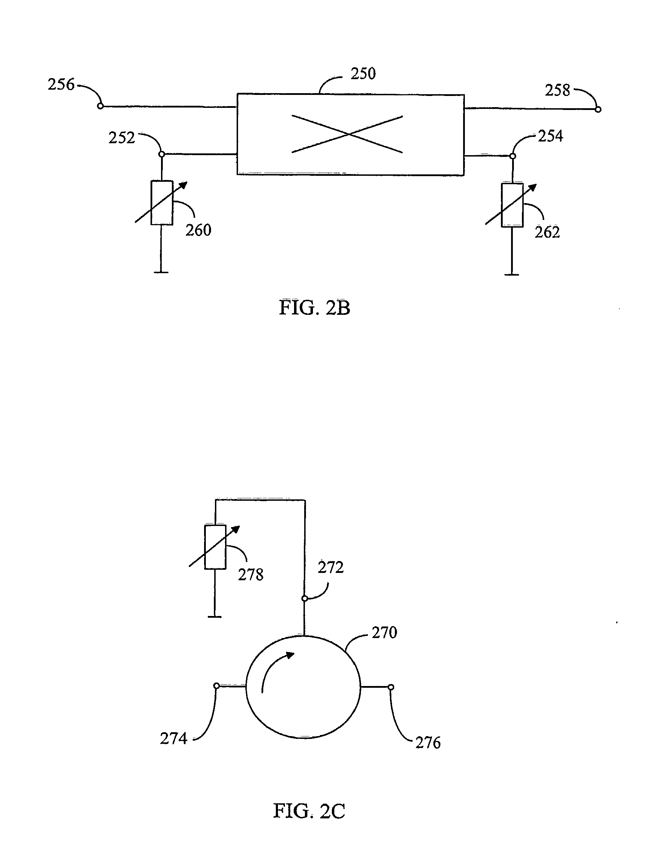

Figure 2B illustrates an example where the matching component is a directional coupler 250 with four terminals 252 to 258. In this example two terminals 252, 254 have adjustable resistance units 260, 262, but generally at least one terminal has an adjustable resistance unit.

Figure 2C illustrates an example where the matching component is a circulator 270 with three terminals 272 to 276. In this example, a terminal 272 has an adjustable resistance unit 278. The terminal 276 is an output terminal when a transmission is transferred from the terminal 274 to the terminal 276. Any one of the other terminals may also have an adjustable resistance unit.

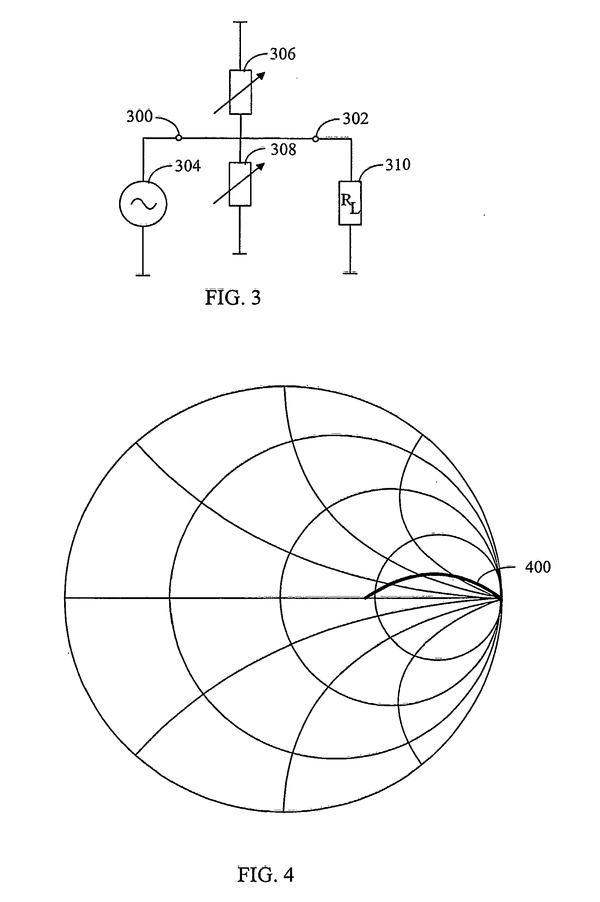

Figure 3 shows another example of the adjusting circuit for adjusting the amplitude of a signal. The adjusting circuit in Figure 3 comprises an input terminal 300 and an output terminal 302. In general, the circuit may have a plurality of terminals for input and output. A signal generator 304 feeds a signal to the input terminal 300. A pair of adjustable impedance units 306, 308 is coupled in parallel between a signal line (the line between the terminals 300, 302) and ground. Ground may be a zero potential or any other reference level against which the signal in the signal line is detected. The impedance unit 306 may be inductive and the impedance unit 308 may be capacitive. Generally the circuit may be provided with more than one pair of adjustable impedance units such that each pair of adjustable impedance units is placed between one pair of input and output terminals. The impedance units of each pair have complementary reactances with respect to each other. A load 310, which may be a non-linear element such as an amplifier, is coupled to the output terminal 302. As in Figures 2A, 2B and 2C, each impedance unit may include many components coupled in parallel and/or in series.

The adjusting circuit described in Figures 2A, 2B, 2C and 3 can be considered an adjustable attenuator because its changeable resistance attenuates the signal input to the load at a desired extent.

The complementary reactances of the impedance units relating to Figures 2A, 2B, 2C and 3 can be mathematically expressed using complex numbers such that an impedance can be considered a complex value a real part of which represents resistance and an imaginary part of which represents reactance. The reactance, in turn, is due to inductance or capacitance. An impedance Z of a parallel coupling of two impedance units $Z_1 = R_1 + JX_1$, $Z_2 = R_2 + jX_2$ can be expressed as

$$\overline{Z} = \frac{1}{\dfrac{1}{Z_1} + \dfrac{1}{Z_2}} = \frac{1}{\dfrac{1}{R_1 + jX_1} + \dfrac{1}{R_2 + jX_2}}, \qquad (1)$$

where $R_1 + jX_1$ is the first impedance unit $Z_1$, $R_2 + jX_2$ is the second impedance unit $Z_2$, $R_1$ is the resistive part of the first impedance unit, $R_2$ is the resistive part of the second impedance unit, $X_1$ is the reactive part of the first impedance unit, $X_2$ is the reactive part of the second impedance unit, and j is the imaginary unit. The impedance Z can also be expressed as

$$Z = \frac{R_1 R_2 + j(R_1 X_2 + R_2 X_1) - X_1 X_2}{R_1 + R_2 + j(X_1 + X_2)}, \qquad (2)$$

which may have a real value, i.e. the impedance Z may be resistive, if the resistive part $R_1$ and the resistive part $R_2$ have the same value, $R_1 = R_2$, and if the reactive part $X_1$ is opposite to the reactive part $X_2$, $X_1 = - X_2$. When the impedance Z is purely resistive, the values of the parallel impedances $Z_1$, $Z_2$ are complex conjugates with respect to each other, i.e. $Z_1 = R_1 + jX_1$, $Z_2 = Z_1 R_1 - jX_1$.

Figure 4 shows a curve 400 of an adjustable impedance unit 2080 of the resistance unit 208 having an inductive reactance on the Smith chart. The curve is similar to that of the impedance unit 306, too. The values of the impedance unit may be selected so that the minimum value and the maximum value of the adjustment range are in the real axis of the Smith chart. The curve of the adjustable impedance unit which does not have complementary reactances is in this case an arch on the Smith chart which curves above the real axis.

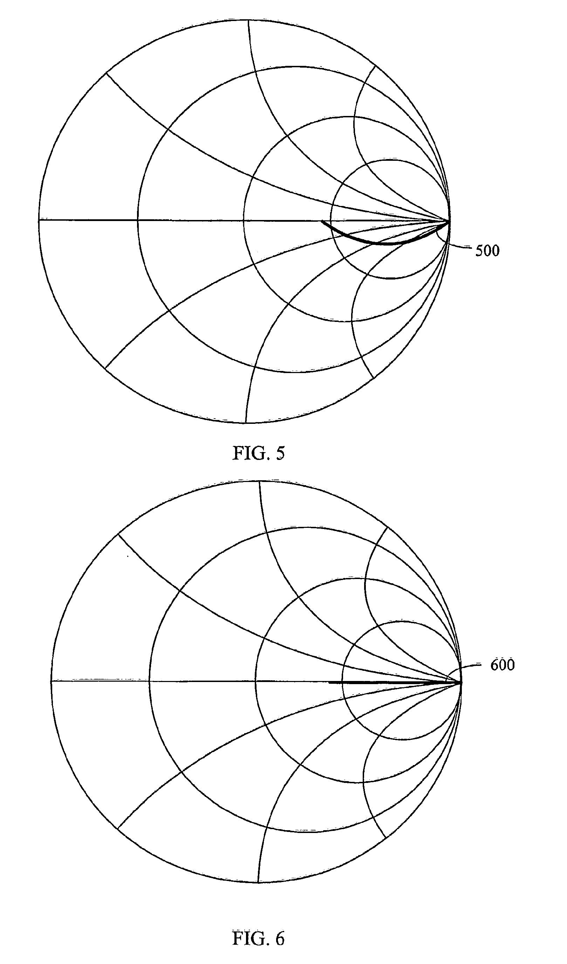

Figure 5 shows a Smith chart having an impedance curve 500 of an impedance unit 2082 of the resistance unit 208 with a capacitive reactance. The curve is similar to that of the impedance unit 308, too. Similarly as in Figure 4, the values of the impedance unit may be selected so that the minimum value and the maximum value of the adjustment range are in the real axis of the Smith chart. The curve of the adjustable impedance unit without complementary reactances is in this case an arch below the real axis on the Smith chart.

Figure 6 shows a Smith chart having a combined impedance curve 600 of an impedance unit 2080 and an impedance unit 2082 of the resistance unit 206. The curve is similar to that of the combination of an impedance unit 306 and an impedance unit 308. Because the complementary reactances (relating to $X_1$ and $X_2$ in the equation (2)) are opposite to each other, the combined impedance Z is resistive and hence a straight line within a full range of adjustment.

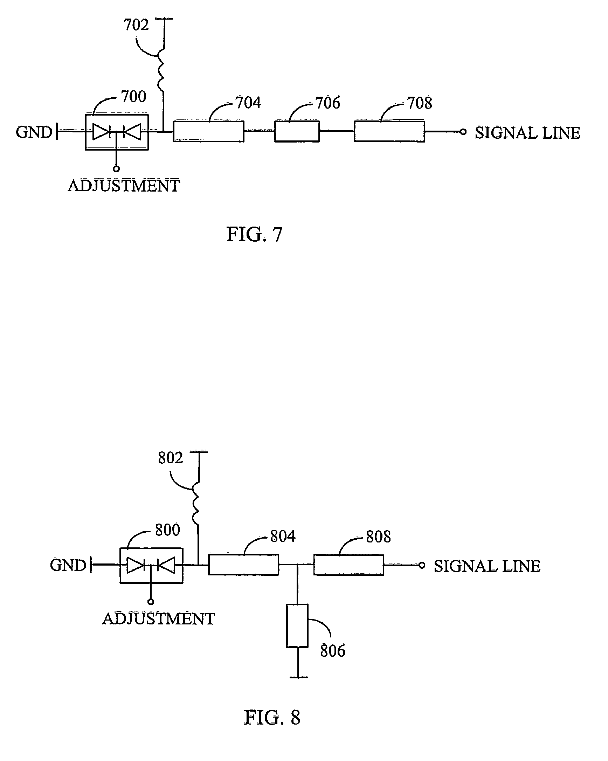

Figure 7 illustrates an impedance unit having a similar behaviour to the curve in Figure 4. The impedance unit may be implemented using a pair of capacitance diodes 700 whose cathodes are facing each other. However, the impedance unit may be implemented using at least one capacitance diode in general. The pair of capacitance diodes 700 has been coupled to ground at one terminal. The adjusting signal adjusting the impedance is fed in between the pair of diodes 700. The adjustment signal can be expressed, for example, as follows: $V_{adjustment} = V_0 - V_c$, where $V_{adjustment}$ is the adjusting voltage, $V_0$ is a constant voltage (for example around 8V), and $V_c$ is a variable voltage changing the impedance of the pair of the capacitance diodes 700. The other terminal of the pair of capacitance diodes 700 has been coupled to ground through a coil 702. The same terminal of the pair of capacitance diodes 700 is also coupled to a signal line through pieces of transmission lines 704, 708 and a resistance 706.

Figure 8 illustrates an impedance unit having a similar behaviour to the curve in Figure 5. Also this impedance unit may be implemented using a pair of capacitance diodes 800 whose cathodes are facing each other. The adjusting signal adjusting the impedance is fed in between the pair of diodes 800. In this case, the adjustment can be performed directly using the variable voltage $V_c$, i.e. $V_{adjustment} = V_c$. The curves thus curve in opposite direction in Figures 4 and 5 and have opposite reactive values with respect to each other at any point of the adjustment range. The other terminal of the pair of capacitance diodes 800 has been coupled to ground through a coil 802. The pair of capacitance diodes 800 is coupled to a signal line through pieces of transmission lines 804, 808 between which there is placed a resistance 806 to ground.

When the frequency is considered to be 2140MHz, the following examples can be given without, however, limiting to these. Each capacitance diode includes an inductance 1.5mH and the values of the components are as follows:

| | |
|---|---|
| transmission line 704 | $Z_0 = 63\Omega$, $I = 0.668*\lambda$ |
| resistance 706 | $R = 120\Omega$ |
| transmission line 708 | $Z_0 = 50\Omega$, $I = 0.107*\lambda$. |
| transmission line 804 | $Z_0 = 50\Omega$, $I = 0.794*\lambda$ |
| resistance 806 | $R = 90\Omega$ |
| transmission line 808 | $Z_0 = 106\Omega$, $I = 0.804*\lambda$. |

As an example the capacitance C of a capacitance diode can be expressed as $C = [8.75/(1 + V_{adjustment}/2.3)^{1.1} + 1.2]pF$. For other frequencies, different values can be used. The coils 702, 802 are used for DC grounding. The use of capacitance diodes makes the adjusting circuit fast and can thus be used at high frequencies.

By coupling the adjustable impedance units of Figure 7 and Figure 8 in parallel, an adjustable resistance may be formed. The adjustable impedances can be designed so that the absolute values of the reactive parts are equal but the values have opposite signs resulting in a straight line on the Smith chart. Capacitance diodes enable a high adjustment speed, high return loss and an adjustment range of up to 5 dB or even more.

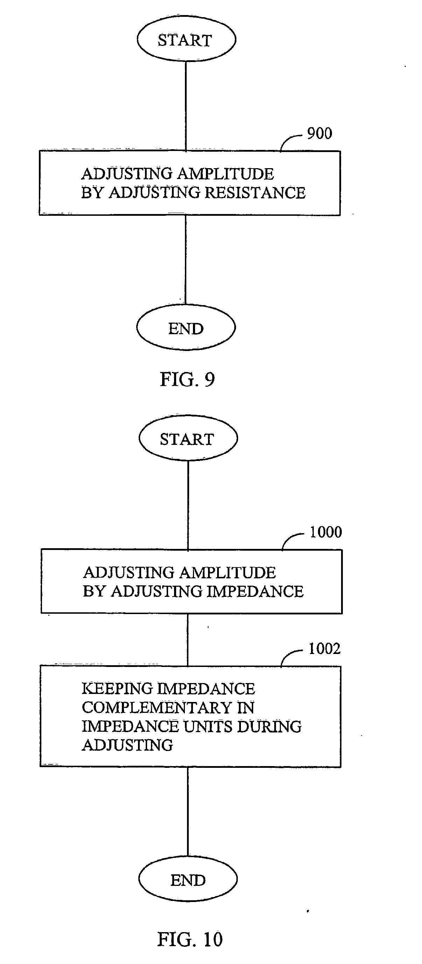

Figure 9 illustrates a flow chart of the method of adjusting an amplitude of a signal in an adjusting circuit. In method step 900 resistance at the input and the output of at least one terminal of the amplitude adjusting circuit is adjusted with the at least one adjustable resistance unit.

Figure 10 illustrates a flow chart of the method of adjusting an amplitude of a signal in an adjusting circuit. In method step 1000, the impedance of the adjusting circuit is adjusted. In step 1002, reactances of the impedance units of each pair are kept complementary with respect to each other during adjusting.

The signal to be adjusted may be a radio frequency signal which may be a base band signal or a signal modulated by a carrier. The frequency of the signal may vary from kilohertzes to gigahertzes.

**Claims**

1. An adjusting circuit for adjusting an amplitude of a signal, the adjusting circuit comprising
    a plurality of terminals (200, 202, 252 to 258, 272 to 276, 300, 302) for input and output; and
    at least one pair of adjustable impedance means (208, 210, 260, 262, 306, 308), wherein each pair of the adjustable impedance means (208, 210, 260, 262, 306, 308) is placed in between a pair of input and output terminals (200, 202, 252 to 258, 272 to 276, 300, 302), in which the each pair of the adjustable impedance means (208, 210, 260, 262, 306, 308) is coupled in parallel between a signal line and ground, and
    the impedance means of the each pair of the adjustable impedance means (208, 210, 260, 262, 306, 308) having complementary reactances with respect to each other such that the impedances are complex conjugates.

2. The circuit of claim 1, wherein the at least one adjustable impedance means (208, 210, 260, 262, 306, 308) of each pair has opposite reactive values with respect to each other at any point of an adjustment range.

3. The circuit of claim 1, wherein the at least one adjustable impedance means (208, 210, 260, 262, 306, 308) includes a pair of capacitance diodes.

4. The circuit of claim 1, wherein the circuit comprises a transmission line (206).

5. The circuit of claim 1, wherein the circuit comprises a directional coupler (250).

6. The circuit of claim 1, wherein the circuit comprises a circulator (270).

7. The circuit of claim 1, wherein feedback is input from an output of a non-linear element (212) to the at least one pair of adjustable impedance means (208, 210, 260, 262, 306, 308) for adjusting the at least one pair of adjustable impedance means (208, 210, 260, 262, 306, 308) according to a feedback signal.

8. A method of adjusting an amplitude of a signal in an adjusting circuit, the adjusting circuit comprising
a plurality of terminals (200, 202, 252 to 258, 272 to 276, 300, 302) for input and output; and
at least one pair of adjustable impedance means (208, 210, 260, 262, 306, 308), wherein each pair of the adjustable impedance means (208, 210, 260, 262, 306, 308) is placed between a pair of input and output terminals (200, 202, 252 to 258, 272 to 276, 300, 302), each of the at least one pair of adjustable impedance means (208, 210, 260, 262, 306, 308) being coupled in parallel between a signal line and ground,
the method comprising
adjusting (1000) impedance of the adjusting circuit; and
keeping (1002) reactances of the adjustable impedance means (208, 210, 260, 262, 306, 308) of each pair complementary with respect to each other during the adjusting such that the impedances are complex conjugates.

9. The method of claim 8, further comprising inputting a feedback signal from an output of a non-linear (212) element to the at least one pair of adjustable impedance means (208, 210, 260, 262, 306, 308) and adjusting the at least one pair of adjustable impedance means (208, 210, 260, 262, 306, 308) according to the feedback signal.

10. The method of claim 8, wherein the adjusting step comprises adjusting the resistance with the at least one adjustable impedance means (208, 210, 260, 262, 306, 308), in which at least one adjustable impedance means (208, 210, 260, 262, 306, 308) includes at least one capacitance diode (700,800).

**Patentansprüche**

1. Justierschaltung zum Justieren einer Amplitude eines Signals, umfassend
eine Mehrzahl von Klemmen (200, 202, 252 bis 258, 272 bis 276, 300, 302) für Eingang und Ausgang; und
mindestens ein Paar justierbarer Impedanzmittel (208, 210, 260, 262, 306, 308), wobei jedes Paar der justierbaren Impedanzmittel (208, 210, 260, 262, 306, 308) zwischen ein Paar von Eingangs- und Ausgangsklemmen (200, 202, 252 bis 258, 272 bis 276, 300, 302) eingefügt wird, wobei jedes Paar der justierbaren Impedanzmittel (208, 210, 260, 262, 306, 308) parallel zwischen einer Signalleitung und Masse gekoppelt wird, und
wobei die Impedanzmittel jedes Paares der justierbaren Impedanzmittel (208, 210, 260, 262, 306, 308) komplementäre Reaktanzen mit Bezug zu einander aufweisen, so dass die Impedanzen komplexe Konjugate sind.

2. Schaltung nach Anspruch 1, wobei das mindestens eine justierbare Impedanzmittel (208, 210, 260, 262, 306, 308) jedes Paares an jedem beliebigen Punkt eines Justierbereichs entgegengesetzte Blindwerte mit Bezug zu einander aufweist.

3. Schaltung nach Anspruch 1, wobei das mindestens eine justierbare Impedanzmittel (208, 210, 260, 262, 306, 308) ein Paar Kapazitätsdioden beinhaltet.

4. Schaltung nach Anspruch 1, wobei die Schaltung eine Übertragungsleitung (206) umfasst.

5. Schaltung nach Anspruch 1, wobei die Schaltung einen Richtungskoppler (250) umfasst.

**6.** Schaltung nach Anspruch 1, wobei die Schaltung einen Zirkulator (270) umfasst.

**7.** Schaltung nach Anspruch 1, wobei Feedback von einem Ausgang eines nichtlinearen Elements (212) in mindestens ein Paar justierbarer Impedanzmittel (208, 210, 260, 262, 306, 308) eingegeben wird, um das mindestens eine Paar justierbarer Impedanzmittel (208, 210, 260, 262, 306, 308) entsprechend eines Feedback-Signals zu justieren,

**8.** Verfahren zum Justieren einer Amplitude eines Signals in einer justierbaren Schaltung, welche Schaltung umfasst:

eine Mehrzahl von Klemmen (200, 202, 252 bis 258, 272 bis 276, 300, 302) für Eingang und Ausgang; und mindestens ein Paar justierbarer Impedanzmittel (208, 210, 260, 262, 306, 308), wobei jedes Paar der justierbaren Impedanzmittel (208, 210, 260, 262, 306, 308) zwischen ein Paar von Eingangs- und Ausgangsklemmen (200, 202, 252 bis 258, 272 bis 276, 300, 302) eingefügt wird, wobei jedes des mindestens einen Paares der justierbaren Impedanzmittel (208, 210, 260, 262, 306, 308) parallel zwischen einer Signalleitung und Masse gekoppelt wird,

wobei das Verfahren umfasst:

Justieren (1000) der Impedanz der Justierschaltung; und
Komplementärhalten (1002), während des Justierens, der Reaktanzen der justierbaren Impedanzmittel (208, 210, 260, 262, 306, 308) jedes Paares mit Bezug zu einander, so dass die Impedanzen komplexe Konjugate sind.

**9.** Verfahren nach Anspruch 8, ferner umfassend das Eingeben eines Feedback-Signals von einem Ausgang eines nichtlinearen (212) Elements in das mindestens eine Paar der justierbaren Impedanzmittel (208, 210, 260, 262, 306, 308) und Justieren des mindestens einen Paares der justierbaren Impedanzmittel (208, 210, 260, 262, 306, 308) entsprechend eines Feedback-Signals.

**10.** Verfahren nach Anspruch 8, wobei der Justierschritt das Justieren des Widerstands mit dem mindestens justierbaren Impedanzmittel (208, 210, 260, 262, 306, 308) umfasst, wobei mindestens ein justierbares Impedanzmittel (208, 210, 260, 262, 306, 308) mindestens eine Kapazitätsdiode (700, 800) beinhaltet.

## Revendications

**1.** Circuit de réglage pour régler une amplitude d'un signal, le circuit de réglage comprenant :

une pluralité de bornes d'entrée et de sortie (200, 202, 252 à 258, 272 à 276, 300, 302) ; et
au moins une paire de moyens d'impédance réglable (208, 210, 260, 262, 306, 308), dans lequel chaque paire de moyens d'impédance réglable (208, 210, 260, 262, 306, 308) est placée entre une paire de bornes d'entrée et de sortie (200, 202, 252 à 258, 272 à 276, 300, 302), dans lequel ladite chaque paire de moyens d'impédance réglable (208, 210, 260, 262, 306, 308) est couplée en parallèle entre une ligne de signal et la terre, et les moyens d'impédance de chaque paire de moyens d'impédance réglable (208, 210, 260, 262, 306, 308) ayant des réactances complémentaires l'un par rapport à l'autre de manière que les impédances soient des conjugués complexes.

**2.** Circuit selon la revendication 1, dans lequel l'au moins un moyen d'impédance réglable (208, 210, 260, 262, 306, 308) de chaque paire a des valeurs réactives différentes l'un par rapport à l'autre en n'importe quel point d'une plage de réglage.

**3.** Circuit selon la revendication 1, dans lequel l'au moins un moyen d'impédance réglable (208, 210, 260, 262, 306, 308) comprend une paire de diodes de capacité.

**4.** Circuit selon la revendication 1, dans lequel le circuit comprend une ligne de transmission (206).

**5.** Circuit selon la revendication 1, dans lequel le circuit comprend un coupleur directionnel (250).

**6.** Circuit selon la revendication 1, dans lequel le circuit comprend un circulateur (270).

**7.** Circuit selon la revendication 1, dans lequel une rétroaction est appliquée en entrée, provenant d'une sortie d'un élément non linéaire (212), à l'au moins une paire de moyens d'impédance réglable (208, 210, 260, 262, 306, 308) pour régler l'au moins une paire de moyens d'impédance réglable (208, 210, 260, 262, 306, 308) en fonction du signal de rétroaction.

8. Procédé de régler une amplitude d'un signal dans un circuit de réglage, le circuit de réglage comprenant :

   une pluralité de bornes d'entrée et de sortie (200, 202, 252 à 258, 272 à 276, 300, 302) ; et
   au moins une paire de moyens d'impédance réglable (208, 210, 260, 262, 306, 308), dans lequel chaque paire de moyens d'impédance réglable (208, 210, 260, 262, 306, 308) est placée entre une paire de bornes d'entrée et de sortie (200, 202, 252 à 258, 272 à 276, 300, 302), chacune de l'au moins une paire de moyens d'impédance réglable (208, 210, 260, 262, 306, 308) étant couplée en parallèle entre une ligne de signal et la terre,
   le procédé comprenant
   le réglage (1000) de l'impédance du circuit de réglage ; et
   le maintien (1002) des réactances des moyens d'impédance réglable (208, 210, 260, 262, 306, 308) de chaque paire complémentaire par rapport aux autres durant le réglage de manière que les impédances soient des conjugués complexes.

9. Procédé selon la revendication 8, comprenant en outre l'application en entrée d'un signal de rétroaction, provenant d'une sortie d'un élément non linéaire (212), à l'au moins une paire de moyens d'impédance réglable (208, 210, 260, 262, 306, 308) et le réglage de l'au moins une paire de moyens d'impédance réglable (208, 210, 260, 262, 306, 308) en fonction du signal de rétroaction.

10. Procédé selon la revendication 8, dans lequel l'étape de réglage comprend le réglage de la résistance avec l'au moins un moyen d'impédance réglable (208, 210, 260, 262, 306, 308), dans lequel au moins un moyen d'impédance réglable (208, 210, 260, 262, 306, 308) comprend au moins une diode de capacité (700, 800).

FIG. 1

FIG. 2A

FIG. 2B

FIG. 2C

FIG. 3

FIG. 4

FIG. 5

FIG. 6

702

700

GND

ADJUSTMENT

704 706 708

SIGNAL LINE

FIG. 7

802

800

GND

ADJUSTMENT

804 808

806

SIGNAL LINE

FIG. 8

START

900

ADJUSTING AMPLITUDE
BY ADJUSTING RESISTANCE

END

FIG. 9

START

1000

ADJUSTING AMPLITUDE
BY ADJUSTING IMPEDANCE

1002

KEEPING IMPEDANCE
COMPLEMENTARY IN
IMPEDANCE UNITS DURING
ADJUSTING

END

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9728598 A